Europäisches Patentamt

European Patent Office

Office européen des brevets

(11) Publication number: **0 265 572**
**A1**

## (12) EUROPEAN PATENT APPLICATION

(21) Application number: 86430042.1

(22) Date of filing: 29.10.86

(51) Int. Cl.4 **H03K 19/094** , H03K 5/02 , H03K 3/356

(43) Date of publication of application:
04.05.88 Bulletin 88/18

(84) Designated Contracting States:
DE FR GB IT

(71) Applicant: **International Business Machines Corporation**
**Old Orchard Road**
**Armonk, N.Y. 10504(US)**

(72) Inventor: **Boudon, Gérard**
**9 rue des Patis**
**F-91540 Mennecy(FR)**
Inventor: **Nuez, Jean-Paul**
**34 rue des Coquelicots**
**F-91540 Mennecy(FR)**
Inventor: **Mollier, Pierre Bernard**
**15 rue de Ponthierry**
**F-77310 Boissise le Roi(FR)**
Inventor: **Yamour, Yiannis John**
**1380 Riverside Drive**
**New York(US)**

(74) Representative: **Klein, Daniel Jacques Henri**
**Compagnie IBM France Département de**
**Propriété Intellectuelle**
**F-06610 La Gaude(FR)**

(54) **High signal sensitivity high speed receiver in CMOS technology.**

(57) A high speed high sensitivity receiver comprising a latch (11) between ground and a strobe signal which provides its power supply and a controlled gating circuit (12) comprised of two transmission gates (TG1, TG2). One (TG1) is connected to the line input signal IN the other (TG2) is connected to a reference voltage REF.

Supply of the latch and turning on/of of the gating device are activated by STOBE and STROBE signals.

Assuming the strobe is at a low level, e.g. at the ground potential, no current is supplied to the latch composed of four transistors (T1,T2,T3,T4), but the transmission gates (TG1 and TG2) are on, connecting OUTC to REF and OUT to IN.

A latching operation between the cross coupled transistors (T1,T2,T3,T4) is started as soon as the strobe is pulled up. The latching operation is then completed when transmission gates (TG1 and TG2) are turned off (after a transit time of the strobe through the inverter T5/T6). The final state depends on the initial condition found on OUT (node A) and OUTC (node B). T1 turns on first, if IN and OUT are lower than REF and OUTC, and vice-versa.

The nodes A and B are pulled quickly to the levels defined by REF and IN when the strobe is switched down, since the latch supply voltage is suppressed and transmission gates (TG1 and TG2) being turned on.

EP 0 265 572 A1

FIG.1

# HIGH SIGNAL SENSITIVITY HIGH SPEED RECEIVER IN CMOS TECHNOLOGY

## Technical Field

## Background of the Invention

Receiver circuits are key elements in digital logic design because of their wide usage; they represent a significant part of the critical delay in the final system including circuits proper. Their sensitivity and noise immunity control the complexity, power dissipation and speed of the off chip drivers. This problem, which has been very crucial in fast bipolar technology for a long time is becoming important in CMOS technology as the latter is reaching high speeds similar to bipolars. Up to now, high voltage swings have been used on signal between MOS chips not only because of power supply standardization (5 volts) but also because on the one hand MOS receivers are slow when driven by small voltage swings and on the other hand they exhibit a poor signal sensitivity.

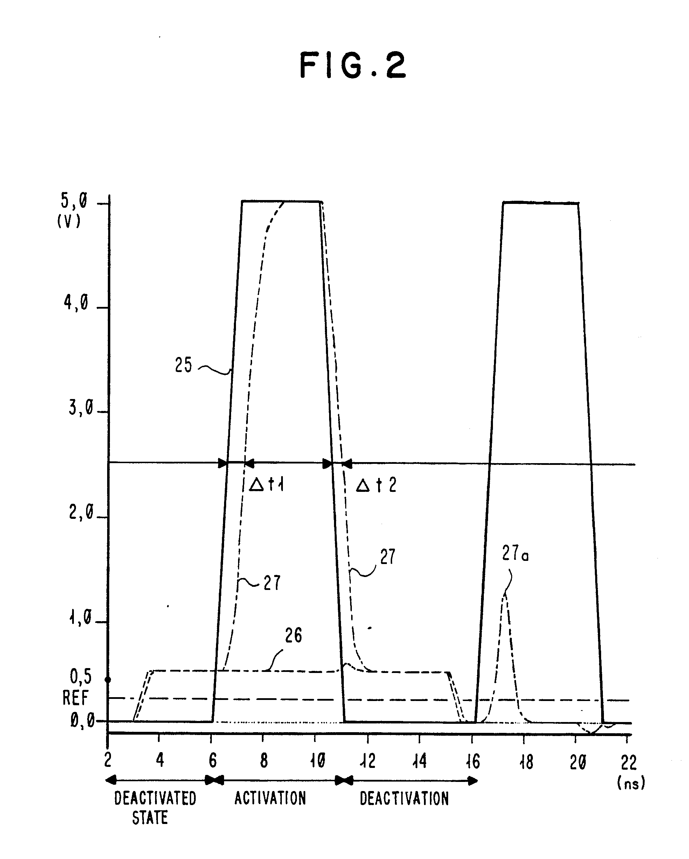

In CMOS technology it is usual practice in the art to have receiver circuits constructed of a plurality of CMOS inverters in series to provide sufficient gain to the input signal and minimum delay. As detailed for example, in the article entitled "A basic cell buffer 44K transistor CMOS masterslice" published in the proceedings of the ISSCC86 pp 78-79. Turning to Fig. 2a of the article, it is shown an input buffer with additional devices (surge protection circuit, paralleled transistors) which illustrates the above statement. This circuit is signal compatible only with high swing voltages (CMOS or TTL, e.g. 5 V) and has a minimum propagation delay time of 1.2 nsec with respect to the input signal with a fan out of 1 (minimum load). The technology used: 1.3 micron may be considered as a state of the art technology. Another example of an advance CMOS receiver is depicted in the IBM Technical Disclosure Bulletin, Vol. 28, No. 8, January 1986, pp 3448-3449, in an article entitled "General purpose interface receiver using short channel CMOS devices". The receiver is of the differential type with a single ended output. The voltage reference generator provides a 1,05 V bias with a 0,350 V variation. Typically, the propagation delay is 1,7 nsec with signal swings of the order of 1,5V. These specifications are still not satisfactory for high performance receivers.

Consequently, there is still a strong need for high speed CMOS receiver having delay less than 1 nsec and operating with low swing voltage say 0,5V.

## Objects of the Invention

It is therefore a primary object of the invention to provide a high speed receiver circuit with a very high signal sensitivity.

## Summary

In accordance with the present invention, a high speed and high signal sensitivity CMOS receiver in CMOS technology, that receives a low swing input signal IN, on its line input terminal, in order to provide a high swing signal OUT on one output terminal, is comprised of the following:

a) a latch including two cross coupled inverters, each one consisting of a pair of complementary transistors having one common end of said inverters connected to a first voltage supply (e.g. GND), the other common end being activated by a STROBE signal;

b) gating means, including a first transmission gate connected between a line input terminal on which said input signal IN is applied and first input terminal of said latch; and, a second transmission gate connected between a terminal on which a reference voltage REF is applied and the second input terminal of said latch. Said transmission gates are activated by the complemented STROBE signal, whereby said gates are off when the latch is active, and vice versa.

## Brief Description of the Drawings

The object and features of the present invention will become more apparent after considering the following detailed description taken in conjunction with the accompanying drawings in which:

Fig. 1 is a schematic illustration of an embodiment of a CMOS high speed, high sensitivity receiver according to the principles of the present invention.

Fig. 2 is an illustration of signal waveforms useful in explaining the operation of the embodiment of Fig. 1.

Fig. 3 is a schematic illustration of another embodiment of a CMOS high speed, high sensitivity receiver according to the principles of the present invention.

## Detailed Description of the Invention

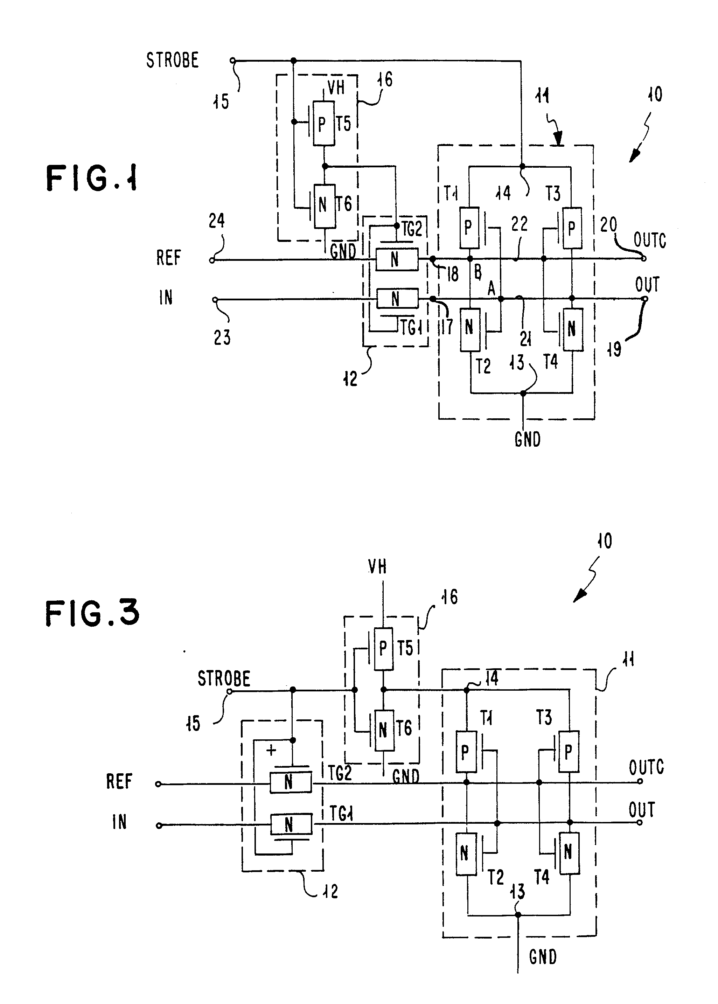

The strobed high speed receiver circuit 10 of the present invention is shown in Fig. 1. Basically, it includes four cross coupled transistors T1, T2, T3 and T4 forming a latch 11, and two input transistors TG1 and TG2 operating as transmission gates forming a controlled gate 12. The latch 11 is biased between a cold point 13, tied to the negative voltage V-(e.g. the ground GND), and a hot point 14 tied to a STROBE terminal 15. The STROBE signal which is applied on terminal 15 varies between V- and a positive voltage V+ (e.g. $V_H$). It is an important feature of the present invention that the gates of input transistors TG1 and TG2 are driven by the complementary signal $\overline{STROBE}$. This is achieved by an inverter arrangement 16 comprised of transistors T5 and T6, so that gate 12 receives the $\overline{STROBE}$ signal while the latch 11 is directly connected the STROBE signal. Latch 11 is provided with input terminals 17,18 and output terminals 19,20, respectively, physically connected by metal lands 21, 22. As apparent from Fig. 1, said input and output terminals of the latch and said metal lands are electrically at the same potential of the internal nodes of the latch which bear references A and B. Input transistor TG1 is connected between input terminal 17 and the line input terminal 23. The signal IN which is applied on the latter is a low swing voltage (e.g. 0-500 mV) provided by an off-chip driver, or a data or transmission line, etc... Input transistor TG2 is connected between input terminal 18 and a terminal 24 which is connected to a reference voltage REF. The value of REF is preferably chosen at the middle level of the line input signal swing. Output signals OUT and OUTC are available on output terminals 19 and 20, respectively.

The circuit operation is as follows:

## Deactivated state

Assuming the strobe is at a low level, e.g. at the ground potential: no current is supplied to the latch composed of T1-T2-T3-T4, but the transistors TG1 and TG2 are on, connecting OUTC to REF and OUT to IN.

The voltage difference $\Delta V$ between the input IN and the reference voltage REF is therefore applied to the latch nodes: OUT and OUTC; the latch is then prepared for activation.

## Activation

A latching operation between T1, T2, T3, T4 is started as soon as the strobe is pulled up. The latching operation is then completed when TG1 and TG2 are turned off (after a transit delay time of the strobe through the inverter T5/T6). The final state depends on the initial condition found on nodes A and B. T1 turns on first, in IN and A are lower than REF and B.

This operation is very fast even though the line input signal is small. This occurs due to the following:
-the strobe is directly applied to the latch without any intermediate stage;
-the internal nodes have already been preset in a differential state with the right polarity during the preparation: they do not have to switch from an opposite state;
-the signal amplification takes place very early on the strobe rising edge if REF is chosen close to ground (at the latest, the amplification starts when the strobe reaches the level of VT(P)+REF, where VT(P) is the threshold voltage of P type transistors.

The circuit sensitivity is very high, only dependent on the device tracking since a differential circuit is used. Its detection level is very precise and can be easily adjusted through the voltage reference REF.

## Deactivation

The nodes A and B are pulled quickly to the levels defined by REF and IN when the strobe is switched down, since the latch supply voltage is suppressed and transistors TG1-TG2 are being turned on.

Fig.2 depicts a typical example of the signal waveforms (voltage versus time) obtained with the receiver circuit of Fig.1, using Computer Aided Circuit Simulations, which a standard CMOS masterslice technology: channel length of 1.3 microns: N channel width: 17,9 $\mu$, P channel width: 23,9 $\mu$, Cwire (wiring capacitance) = 0,1 pF, and a supply voltage VH = 5 Volts. The reference voltage REF is fixed at 250 mV. The strobe signal referenced 25 is a periodic (T = 10 nsec), high swing (5 Volts) pulse. The IN signal referenced 26 is a low swing voltage operating between GND (logical "0") and + 500 mVolts (logical "1"). The signal available at the output terminal 19 of Fig. 1 termed OUT is referenced 27. In the deactivated state, when signal IN is applied to the receiver circuit on terminal 23, at time 3 nsec, the output signal corresponds to the IN signal with a negligible delay, because TG 1 is on.

When the strobe is applied at time 6 nsec, the latch comprised of transistors T1, T2, T4 and T4 is activated, and node A which was ata little less than 0,5V switches very fast with a short delay (Δt 1) to reach the maximum amplitude 5 Volts, in phase with the IN signal (the complementary signal OUTC is available on terminal 20). When at time 10 nsec, the strobe is pulled down, the OUT signal follows with a very short delay (Δt 2), to reach the level of the IN signal because the latch is deactivated again. If the IN signal is at the "0" level, when the strobe signal is applied (e.g. at time 16 nsec), the OUT signal exhibits a peak of voltage referenced 27a which is less than the noise immunity (around 2 Volts) of the CMOS circuits, and therefore causes no trouble before reaching the potential of the ground. As it is clear from the drawing the circuit provides a typical delay Δt1 = 0,65 ns at 50% of the the output voltage swing on the rising edge and Δt2 = 0,5 ns on the falling edge. The results are significantly better than those obtained in the prior references, such as discussed above. Because of these very short delays Δt1 and Δt2, the circuit switches fast and the period of the STROBE signal may be significantly decreased at a minimum therefore increasing the operating speed of the receiver circuit. This is made clear from Fig. 2 where IN is in the "0" level at time 15,5 nsec and the STROBE is applied only 0,5 nsec after.

Fig.3 shows an alternative to the circuit of Fig. 1. The strobe inverter T5-T6 can be placed on the path that feeds the latch inself instead of driving the input transistors TG1 and TG2.

With respect to circuits shown in Figs. 1 and 3, it is to be noted that the strobe inverter can also be omitted, provided that the strobe and its complement are supplied. The strobe inverter may be useful if the latch is comprised of large transistors, in other words, if high currents are necessary to feed the latch. But this is done at the cost of extra devices and delays. However, this solution can help decreasing the number of devices when several latches are simultaneously strobed.

It must also be pointed out that the electrical - schematic of the circuit shown in Fig. 3 is based on the same principle as the standard sense amplifiers used in dynamic RAM's. See for example, the article entitled "double port RAM in CMOS technology" published in the IBM Technical Disclosure Bulletin, Vol. 28, No. 4, September 1985, pp 1613-1614. However instead of being differentially connected to the two memory bit lines, the circuit is connected between the chip input IN and an adequate voltage reference REF, preferably chosen at the middle level of the signal swing (receiver threshold). Another fundamental distinction is that according to the teachings of the present invention, the latch is not used to store a data, but only its ability to switch fast is retained. In other words: in the circuit of the present invention, the latch operates more like a loop amplifier with an infinite gain than a memory cell.

The strobed high speed receiver circuits as shown in Figs.1 and 3 exhibit several advantages:
-it has the ability to detect very low input swings (a few hundred millivolts);
-it has an adjustable threshold: because REF may be freely chosen, the circuits of the present invention are usable within a wide range of power supplies (e.g.: + 250 mV, -250 mV, 0,-500 mV...);
-it is a high speed circuit, very similar to an inverter;
-it is comprised of complementary devices therefore there is no DC current in the quiescent state;
-because it is a strobed latch: the circuit latches the data and it is then insensitive to the input signal IN when the strobe is high. The latch is isolated from the input signal IN since the transmission gate TG1 is turned off. A new information (data) can be therefore prepared while the previous one is being used;
-it may be implemented in a gate array circuit.

All these advantages are obtained only at the cost of a strobe which is required to define the sampling time. This may be a disadvantage only in logic circuits, but seldomly in memory circuits, where a strobe is generally available on a chip. In addition, input impedance is lower than when driving a transistor gate (higher transients).

Applications

The strobed high speed CMOS receiver circuit of the present invention operating with low voltage swings, may find a very wide field of applications once integrated in a semiconductor chip and is more specially well suited to:
-memories where address and data inputs need to be latched during cycle time (may save a latch per input); such memories are widely used, then the STROBE signal will be $\overline{CS}$ (Chip Select);
-bipolar ECL to FET signal transmission for interface needs; and
-transmission between chips using different power supplies.

While the invention has been described in its preferred embodiments, it is to be understood that the words that have been used are words of description rather than limitation, and that changes may be made within the purview of the appended claims without departing form the true scope and spirit of the present invention in its broader aspects.

## Claims

1. High speed and high signal sensitivity receiver (10) in CMOS technology receiving a low swing input signal IN on its line input terminal (23) to provide a high swing signal OUT on one output terminal (19) comprising:

latching means (11) including two cross coupled inverters, each comprised of a pair of complementary transistors (T1, T2 and T3, T4) having one common end (13) of said inverters connected to a first supply voltage and the other common end (14) being activated by a STROBE signal; and

controlled gating means (12) including a first transmission gate (TG1) connected between a line input terminal (23) on which said input signal IN is applied and a first input terminal (17) of said latching means; and, a second transmission gate (TG2) connected between a terminal (24) on which a reference voltage REF is applied and the second input terminal (18) of said latching means; said transmission gates being activated by the complemented STROBE signal, whereby, said gating means are off when the latching means are active, and vice versa.

2. High speed and high signal sensitivity receiver according to claim 1 wherein said reference voltage REF is selected at about the middle of the signal swing applied to said line input terminal.

3. High speed and high signal sensitivity receiver according to claim 2 wherein said complementation is achieved by an inverter (16) including a pair of complementary transistors (T5, T6).

4. High speed and high signal sensitivity receiver according to claim 3 wherein said inverter has its input connected to the STROBE terminal (15) and its output connected to the gates of said transmission gates (TG1, TG2).

5. High speed and high signal sensitivity receiver according to claim 3 wherein said inverter has its input connected to the STROBE terminal (15) and its output connected to said other common end (14) of the latching means, while the gates of said transmission gate are connected to said STROBE terminal.

# FIG.1

STROBE

15

VH

T5 P 16

N T6

24 REF

23 IN

GND

TG2

N

TG1

N

12

T1 P 14 T3 P 20 OUTC

22

18 B A 21

17 N T2 N 19 OUT

13 T4

GND

# FIG.3

VH

T5 P 16

STROBE

15

N T6 GND

+ N TG2

N TG1

12

11

14

T1 P T3 P OUTC

T4

T2 N 13 T4 N OUT

GND

# FIG.2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 110 060 (INTERNATIONAL BUSINESS MACHINES CORP.) * figure 2, elements 22, 23, 15; page 4, line 20 - page 5, lines 7, 33 - page 6, line 5 * | 1 | H 03 K  19/094 <br> H 03 K   5/02 <br> H 03 K   3/356 |
| A | PATENT ABSTRACTS OF JAPAN, vol. 8, no. 25 (E-225)[1462], 2nd February 1984; & JP - A - 58 186 217 (NIPPON DENKI K.K.) 31-10-1983 * abstract; figures 2a-2c * | 1 | |
| A | DE-B-2 745 302 (EUROSIL GMBH) * figures 1, 2; column 6, line 4 - column 10, line 2 * | 1 | |
| A | US-A-3 879 621 (J.R. CAVALIERE et al.) * figure 2 * | 1 | TECHNICAL FIELDS SEARCHED (Int. Cl.4) |
| A | IBM TECHNICAL DISCLOSURE BULLETIN, vol. 27, no. 10B, March 1985, pages 6023-6024 "Receiver for clocked or pseudoclocked cascode voltage swit ch logic" | | G 01 R  19/165 <br> H 03 F   3/45 <br> H 03 K   3/353 <br> H 03 K   3/356 <br> H 03 K   5/02 <br> H 03 K   5/08 <br> H 03 K   5/24 <br> H 03 K  17/30 <br> H 03 K  19/094 <br> H 04 L  25/20 <br> H 04 L  25/24 <br> H 04 L  25/40 <br> H 04 L  25/45 |

The present search report has been drawn up for all claims

| Place of search | Date of completion of the search | Examiner |
|---|---|---|
| BERLIN | 25-05-1987 | ARENDT M |